# EUROPÄISCHE PATENTSCHRIFT

(11) **EP 3 915 193 B1**
(45) Veröffentlichungstag und Bekanntmachung des Hinweises auf die Patenterteilung: **15.02.2023**
(21) Anmeldenummer: 20710796.2
(22) Anmeldetag: 26.02.2020
(51) Int. Cl.: H03K 17/16, H03K 17/082, H03K 17/04, H03K 17/042

(54) **BESCHALTUNG EINES HALBLEITERSCHALTERS**
CONNECTION OF A SEMICONDUCTOR SWITCH
CIRCUIT D'UN COMMUTATEUR À SEMI-CONDUCTEUR

(30) Priorität: 01.04.2019 EP 19166563
(43) Veröffentlichungstag der Anmeldung: 01.12.2021
(73) Patentinhaber: Siemens Aktiengesellschaft, 80333 München (DE)
(72) Erfinder: HIRSCH, Lucia, 09113 Chemnitz (DE); ROPPELT, Bernd, 96173 Unterhaid (DE); SCHWINN, Thomas, 91074 Herzogenaurach (DE)
(86) Internationale Anmeldenummer: PCT/EP2020/055036
(87) Internationale Veröffentlichungsnummer: WO 2020/200591

(56) Entgegenhaltungen:
- EP-A1- 3 051 697
- EP-A2- 0 730 331
- EP-A2- 0 902 537
- DE-A1- 19 634 612
- US-A- 5 376 831

## Beschreibung

Die Erfindung betrifft eine Beschaltung eines Halbleiterschalters.

Beim Schalten von Halbleitern, beispielsweise IGBTs, MOSFETs, etc. entstehen Spannungsschaltflanken (du/dt). Diese verlaufen meist nichtlinear, so dass zum einen eine maximale Spannungssteilheit (du/dt_max) und zum anderen eine mittlere Spannungssteilheit (beispielsweise 10%-90%-Wert) für die IGBT-Abstimmung (Gatewiderstandsabstimmung) betrachtet werden muss.

Die maximale Spannungssteilheit bei Leistungshalbleitern muss für bestimmte Anwendungen begrenzt werden, da zu hohe Spannungsflanken Probleme bezüglich der elektromagnetischen Verträglichkeit (EMV) verursachen, sowie bei leistungselektronischen Schaltern zu Schäden an den Wicklungen eventuell angeschlossener Maschinen führen können.

Bei einfachen Ansteuerschaltungen, z.B. nur mit einem Gatewiderstand, wird zur Einstellung der maximalen Spannungssteilheit der Gatewiderstand angepasst. Wird die maximale Spannungssteilheit durch den Gatewiderstand begrenzt, verlangsamt sich auch die mittlere Spannungssteilheit. Verlangsamte Schalthandlungen führen zu erhöhten Schaltverlusten im Halbleiterschalter, was sich bei gleichem Kühlsystem negativ auf die Lebensdauer des Halbleiterschalters und des Umrichters auswirkt.

Ziel ist es, die Maximalwerte der Spannungssteilheit beim Schalten zu reduzieren, ohne die mittlere Spannungssteilheit zu beeinflussen, das heißt die Schaltflanke zu linearisieren.

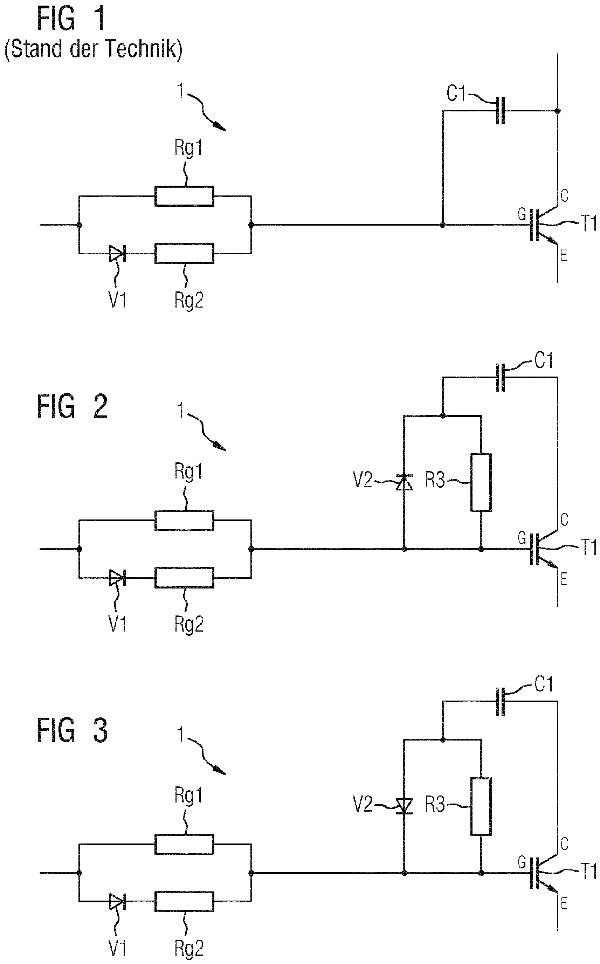

Aus dem Stand der Technik ist bekannt, wie in Figur 1 gezeigt, hierzu einen Kondensator C1 zwischen dem Kollektor C und dem Gate G anzuordnen. Spannungsflanken im Lastkreis bewirken über den Kondensator C1 einen Verschiebestrom, der auf das Gate G zurückgeführt wird und dieses so lädt bzw. entlädt dass es der Schaltflanke entgegenwirkt (Gegenkopplung).

Hierdurch kann die Spannungsflanke quasi auf einen Wert geregelt eingestellt werden.

Die in Figur 1 dargestellte Gatewiderstandsbeschaltung aus V1, Rg1 und Rg2 dient zur Abbildung zweier voneinander unabhängiger Gatewiderstände Rg_on (Rg1 parallel Rg2) und Rg_off (=Rg1). Eine Entkopplung der Gatewiderstände würde auch eine Diode in entgegengesetzter Flussrichtung bewirken.

Durch die zusätzliche Kapazität C1 wird allerdings das Einschalten- und Ausschalten im gleichen Maß beeinflusst. Bei bestimmten Halbleitern (beispielsweise IGBTs neuerer Generation) bewirkt ein optimaler Kapazitätswert für das Einschalten eine Verlangsamung des Schaltvorgangs, die mit einem kleineren Gatewiderstand kompensiert werden muss. Dies führt in den meisten Fällen beim Ausschalten zwar zu gleichen Schaltflanken, bringt jedoch keinerlei Verbesserung hinsichtlich Verluste und führt zu höherer Abschaltüberspannung.

Das Problem wurde bis jetzt nur mit aufwendigen und teuren Treiberschaltungen (z.B. Treiberschaltung mit geregelter Stromquelle) beherrscht. Bei einfachen Gatetreiberschaltungen wird ein Kompromiss zwischen Ein- und Ausschalten geschlossen. Eine optimale Einstellung ist in diesem Fall nicht möglich.

Die US 5 376 831 A lehrt einen Schaltkreis, welcher mittels einer Beschaltung von elektronischen Bauelementen an einem Leistungshalbleiter des Schaltkreises einen steuerbaren Anfangsstrom von einer Stromversorgung zu einer Last erzeugt, insbesondere dann, wenn der Schaltkreis im Betrieb ausgetauscht wird oder wenn beim Einschalten zum ersten Mal eine Energieversorgung an den Schaltkreis angelegt wird. Durch diesen sanften Start der Last, z.B. einer kapazitiven Last, wird ein hoher Anfangsstrom verhindert.

Die EP 0 730 331 A2 betrifft eine Schaltungsanordnung zur Begrenzung von Schaltüberspannungen an Leistungshalbleiterschaltern, die über ihren Steuereingang ein- und ausschaltbar sind, insbesondere an in einem Zweig eines Stromrichters angeordneten Leistungshalbleiterschalter-Paaren.

Der Erfindung liegt die Aufgabe zugrunde, eine verbesserte Beschaltung für einen Halbleiterschalter anzugeben.

Die Aufgabe wird erfindungsgemäß durch eine Beschaltung mit den Merkmalen des Anspruchs 1 gelöst.

Vorteilhafte Ausgestaltungen der Erfindung sind Gegenstand der Unteransprüche.

Gemäß einem ersten Aspekt der vorliegenden Erfindung wird eine Beschaltung eines Halbleiterschalters, umfassend ein Gate, einen Kollektor oder ein Drain und einen Emitter oder ein Source, vorgeschlagen, wobei die Beschaltung einen Kondensator zwischen Gate und Kollektor oder Drain umfasst, wobei in Reihe zum Kondensator eine Parallelschaltung aus einem Widerstand und einer Diode vorgesehen ist.

Die Diode ist in Flussrichtung vom Gate weg geschaltet. Somit wird nur das Einschaltverhalten des Halbleiterschalters beeinflusst und/oder verbessert.

Würde diese Diode in Flussrichtung zum Gate hin geschaltet, wird nur das Ausschaltverhalten des Halbleiterschalters beeinflusst und/oder verbessert.

Die Diode ist in Flussrichtung vom Gate weg geschaltet, wobei parallel zur Anordnung aus Kondensator, Widerstand und Diode eine weitere Anordnung aus einem weiteren Kondensator, einem weiteren Widerstand und einer weiteren Diode geschaltet ist, wobei in Reihe zum weiteren Kondensator eine Parallelschaltung aus dem weiteren Widerstand und der weiteren Diode vorgesehen ist, wobei die weitere Diode in Flussrichtung zum Gate hin anliegt. Somit wird das Ein- und Ausschaltverhalten des Halbleiterschalters (unabhängig voneinander) beeinflusst und/oder verbessert.

In einer nicht zur Erfindung gehörenden Beschaltung ist dem Widerstand und der Diode ein weiterer Kondensator parallel geschaltet.

Gemäß einem zweiten Aspekt, welcher nicht zu der vorliegenden Erfindung gehört, wird eine Beschaltung eines Halbleiterschalters, umfassend ein Gate, einen Kollektor oder ein Drain und einen Emitter oder ein Source vorgeschlagen, wobei die Beschaltung einen Kondensator zwischen Gate und Kollektor oder Drain umfasst, wobei parallel zum Kondensator eine Schaltung vorgesehen ist, in der eine Diode in Reihe zu einer Parallelschaltung aus einem Widerstand und einem weiteren Kondensator geschaltet ist.

Die Diode kann dabei in Flussrichtung vom Gate weg oder zum Gate hin geschaltet sein.

In einer Ausführungsform ist eine Gatewiderstandsbeschaltung vorgesehen, umfassend einen am Gate angeschlossenen ersten Gatewiderstand, dem eine Reihenschaltung aus einem zweiten Gatewiderstand und einer Gatediode parallel geschaltet ist, wobei die Gatediode so geschaltet ist, dass sie einen Stromfluss zum Gate zulässt.

In einer nicht zur Erfindung gehörenden Beschaltung wird der Entladewiderstand parallel zum Kondensator oder parallel zur Diode geschaltet.

In einer Ausführungsform ist der Halbleiterschalter als ein IGBT oder ein MOSFET ausgebildet.

Die Vorteile der Erfindung liegen in der besseren Ausnutzung des Halbleiterschalters, bedingt durch:
Entkopplung von Ein-und Ausschaltverhalten und getrennte Anpassung maximaler und mittlerer Schaltflanken.

Daraus resultiert:
- niedrigere Abschaltüberspannung des Leistungshalbleiters
- geringere Schaltverluste
- verbesserte elektromagnetische Verträglichkeit (EMV)
- mögliche kompaktere Bauweise von Umrichtern, auf Grund von geringeren Verlustleistungen der Leistungshalbleiter.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine aus dem Stand der Technik bekannte Beschaltung eines Halbleiterschalters,
- FIG 2: eine Beschaltung eines Halbleiterschalters,
- FIG 3: eine Beschaltung eines Halbleiterschalters,
- FIG 4: eine Ausführungsform einer Beschaltung eines Halbleiterschalters,
- FIG 5: eine nicht zur Erfindung gehörende Beschaltung eines Halbleiterschalters,
- FIG 6: eine nicht zur Erfindung gehörende Beschaltung eines Halbleiterschalters,
- FIG 7: eine nicht zur Erfindung gehörende Beschaltung eines Halbleiterschalters, und
- FIG 8: eine nicht zur Erfindung gehörende Beschaltung eines Halbleiterschalters.

Einander entsprechende Teile sind in allen Figuren mit den gleichen Bezugszeichen versehen.

Figur 1 zeigt eine aus dem Stand der Technik bekannte Beschaltung 1 eines Halbleiterschalters T1. Der Halbleiterschalter T1 ist beispielsweise ein Feldeffekttransistor, insbesondere ein MOSFET oder ein IGBT und weist ein Gate G, einen Kollektor C und einen Emitter E auf. Zwischen Kollektor C und Gate G ist ein Kondensator C1 angeordnet. Es ist eine Gatebeschaltung aus einem ersten Gatewiderstand Rg1, einem zweiten Gatewiderstand Rg2 und einer Gatediode V1 abgebildet, die wie oben in der Einleitung ausgeführt, den Gatewiderstand symbolisiert.

Figur 2 zeigt eine Beschaltung 1 eines Halbleiterschalters T1.

Der Halbleiterschalter T1 ist beispielsweise ein Feldeffekttransistor, insbesondere ein MOSFET oder ein IGBT und weist ein Gate G, einen Kollektor C und einen Emitter E auf. Zwischen Kollektor C und Gate G ist ein Kondensator C1 angeordnet. Es ist eine Gatebeschaltung aus einem ersten Gatewiderstand Rg1, einem zweiten Gatewiderstand Rg2 und einer Gatediode V1 abgebildet, die wie oben in der Einleitung ausgeführt, den Gatewiderstand symbolisiert. Im Unterschied zur Figur 1 ist jedoch zwischen Kollektor C und Gate G in Reihe zum Kondensator C1 eine Parallelschaltung aus einem Widerstand R3 und einer Diode V2 vorgesehen, wobei die Diode V2 in Flussrichtung vom Gate G weg geschaltet ist.

Durch das Einfügen der Diode V2 wird der Eingriff des Kondensators C1 für das Einschalten und Ausschalten voneinander entkoppelt. Mit der in Figur 2 gezeigten Ausführungsform wird nur das Einschaltverhalten beeinflusst und/oder verbessert.

Der Widerstand R3 dient dazu, den Kondensator C1 zu entladen, wenn dies durch die Diode V2 durch Betrieb in ihrer Sperrrichtung nicht möglich ist.

Die Orientierung der Diode V2 bestimmt, ob die Beschaltung 1 beim Einschalten oder Ausschalten des Halbleiterschalters T1 wirkt.

Figur 3 zeigt eine Beschaltung 1 eines Halbleiterschalters T1.

Die Beschaltung 1 ähnelt der in Figur 2 gezeigten Beschaltung 1. Im Unterschied dazu ist jedoch die Diode V2 in Flussrichtung zum Gate G hin geschaltet.

Durch das Einfügen der Diode V2 wird der Eingriff des Kondensators C1 für das Einschalten und Ausschalten voneinander entkoppelt. Mit der in Figur 3 gezeigten Ausführungsform wird nur das Ausschaltverhalten beeinflusst und/oder verbessert.

Der Widerstand R3 dient dazu, den Kondensator C1 zu entladen, wenn dies durch die Diode V2 durch Betrieb in ihrer Sperrrichtung nicht möglich ist.

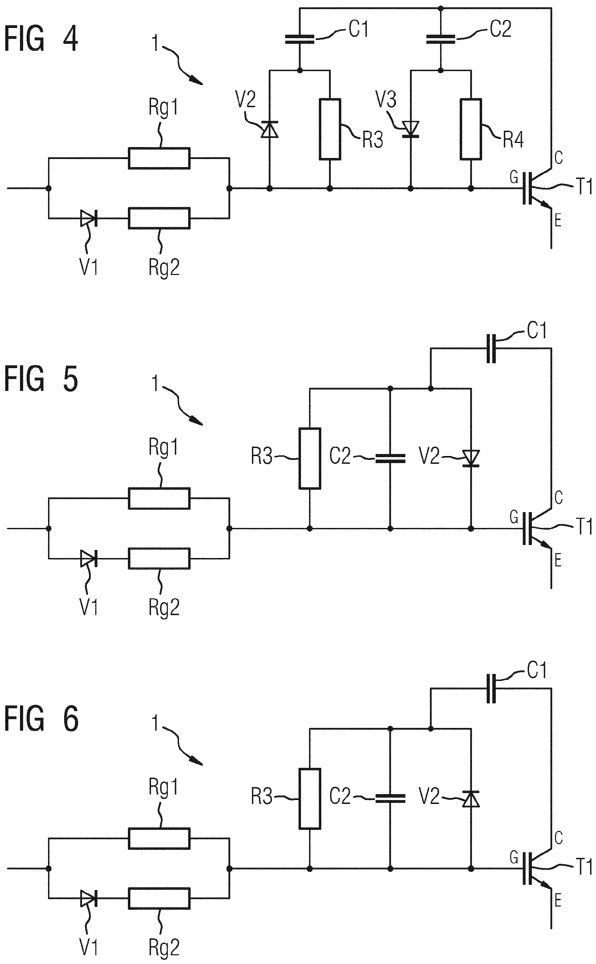

Figur 4 zeigt eine Ausführungsform einer Beschaltung 1 eines Halbleiterschalters T1.

Die Beschaltung 1 kombiniert die in den Figuren 2 und 3 gezeigten Beschaltungen 1.

Zwischen Kollektor C und Gate G ist in Reihe zum Kondensator C1 eine Parallelschaltung aus einem Widerstand R3 und einer Diode V2 vorgesehen, wobei die Diode V2 in Flussrichtung vom Gate G weg geschaltet ist. Parallel zur Anordnung aus Kondensator C1, Widerstand R3 und Diode V2 ist eine weitere Anordnung aus einem weiteren Kondensator C2, einem weiteren Widerstand R4 und einer weiteren Diode V3 geschaltet, wobei der weitere Kondensator C2 beispielsweise am Kollektor C anliegt und in Reihe zum weiteren Kondensator C2 eine Parallelschaltung aus dem weiteren Widerstand R4 und der weiteren Diode V3 vorgesehen ist, wobei die weitere Diode V3 in Flussrichtung zum Gate G hin geschaltet ist.

Mit der in Figur 4 gezeigten Ausführungsform wird das Ein-und Ausschaltverhalten getrennt voneinander beeinflusst und/oder verbessert.

Figur 5 zeigt eine nicht zur Erfindung gehörende Beschaltung 1 eines Halbleiterschalters T1.

Die Beschaltung 1 ähnelt der in Figur 3 gezeigten Beschaltung 1. Im Unterschied dazu ist dem Widerstand R3 und der Diode V2 ein weiterer Kondensator C2 parallel geschaltet.

Figur 6 zeigt eine nicht zur Erfindung gehörende Beschaltung 1 eines Halbleiterschalters T1.

Die Beschaltung 1 ähnelt der in Figur 2 gezeigten Beschaltung 1. Im Unterschied dazu ist dem Widerstand R3 und der Diode V2 ein weiterer Kondensator C2 parallel geschaltet.

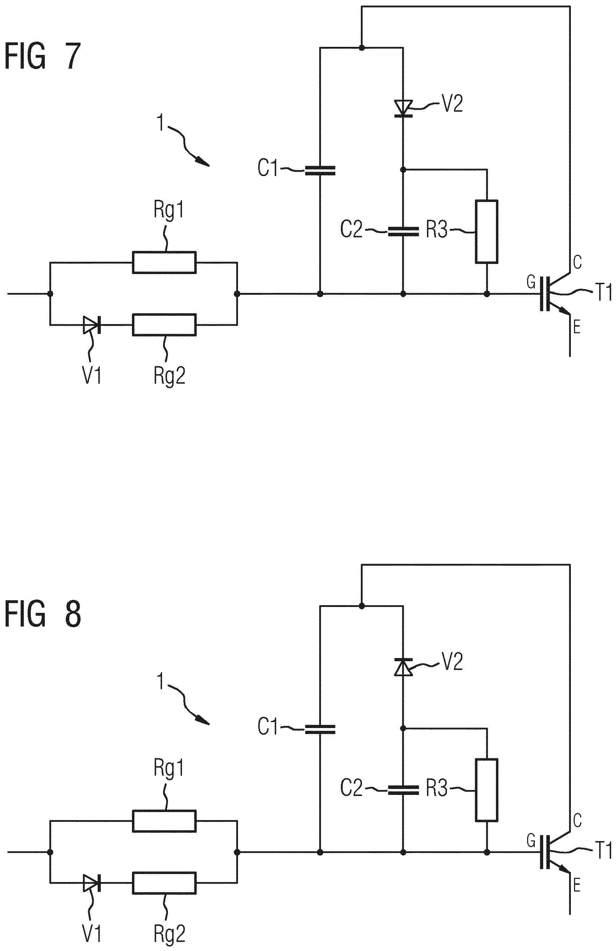

Figur 7 zeigt eine nicht zur Erfindung gehörende Beschaltung 1 eines Halbleiterschalters T1.

Die Beschaltung 1 ähnelt der in Figur 1 gezeigten Beschaltung 1. Im Unterschied dazu ist jedoch zum Kondensator C1 parallel eine Schaltung vorgesehen, in der eine Diode V2 in Reihe zu einer Parallelschaltung aus einem Widerstand R3 und einem weiteren Kondensator C2 geschaltet ist. Dabei ist die Diode V2 in Flussrichtung zum Gate G hin geschaltet.

FIG 8 zeigt eine nicht zur Erfindung gehörende Beschaltung 1 eines Halbleiterschalters T1.

Die Beschaltung 1 ähnelt der in Figur 1 gezeigten Beschaltung 1. Im Unterschied dazu ist jedoch zum Kondensator C1 parallel eine Schaltung vorgesehen, in der eine Diode V2 in Reihe zu einer Parallelschaltung aus einem Widerstand R3 und einem weiteren Kondensator C2 geschaltet ist. Dabei ist die Diode V2 in Flussrichtung vom Gate G weg geschaltet.

In einer Ausführungsform wird der Widerstand R3 parallel zum weiteren Kondensator C2 oder parallel zur Diode V2 geschaltet.

## Patentansprüche

1. Beschaltung (1) eines Halbleiterschalters (T1), umfassend ein Gate (G), einen Kollektor (C) oder ein Drain und einen Emitter (E) oder ein Source, wobei die Beschaltung (1) einen Kondensator (C1) zwischen Gate (G) und Kollektor (C) oder Drain umfasst, wobei in Reihe zum Kondensator (C1) eine Parallelschaltung aus einem Widerstand (R3) und einer Diode (V2) vorgesehen ist, wobei die Diode (V2) in Flussrichtung vom Gate (G) weg geschaltet ist, **dadurch gekennzeichnet, dass** parallel zur Anordnung aus Kondensator (C1), Widerstand (R3) und Diode (V2) eine weitere Anordnung aus einem weiteren Kondensator (C2), einem weiteren Widerstand (R4) und einer weiteren Diode (V3) geschaltet ist, wobei in Reihe zum weiteren Kondensator (C2) eine Parallelschaltung aus dem weiteren Widerstand (R4) und der weiteren Diode (V3) vorgesehen ist und wobei die weitere Diode (V3) in Flussrichtung zum Gate (G) hin geschaltet ist.

2. Beschaltung (1) nach Anspruch 1, wobei eine Gatewiderstandsbeschaltung vorgesehen ist, umfassend einen am Gate (G) angeschlossenen ersten Gatewiderstand (Rg1), dem eine Reihenschaltung aus einem zweiten Gatewiderstand (Rg2) und einer Gatediode (V1) parallel geschaltet ist, wobei die Gatediode (V1) in Flussrichtung zum Gate (G) hin geschaltet ist.

3. Beschaltung (1) nach einem der vorhergehenden Ansprüche, wobei der Halbleiterschalter (T1) als ein IGBT oder ein MOSFET ausgebildet ist.

## Claims

1. Wiring (1) of a semiconductor switch (T1), comprising a gate (G), a collector (C) or a drain and an emitter (E) or a source, wherein the wiring (1) comprises a capacitor (C1) between gate (G) and collector (C) or drain, wherein a parallel connection consisting of a resistor (R3) and a diode (V2) is provided in series with the capacitor (C1), wherein the diode (V2) is connected away from the gate (G) in the flow direction, **characterised in that** connected in parallel with the arrangement consisting of capacitor (C1), resistor (R3) and diode (V2) is a further arrangement consisting of a further capacitor (C2), a further resistor (R4) and a further diode (V3), wherein a parallel connection consisting of the further resistor (R4) and the further diode (V3) is provided in series with the further capacitor (C2) and wherein the further diode (V3) lies toward the gate (G) in the flow direction.

2. Wiring (1) according to claim 1, wherein a gate resistor wiring is provided, comprising a first gate resistor (Rg1) connected at the gate (G), with which first gate resistor a series connection consisting of a second gate resistor (Rg2) and a gate diode (V1) is connected in parallel, wherein the gate diode (V1) is connected toward the gate (G) in the flow direction.

3. Wiring (1) according to one of the preceding claims, wherein the semiconductor switch (T1) is embodied as an IGBT or a MOSFET.

## Revendications

1. Montage (1) d'un interrupteur (T1) à semiconducteur, comprenant une grille (G), un collecteur (C) ou un drain et un émetteur (E) ou une source, dans lequel le montage (1) comprend un condensateur (C1) entre la grille (G) et le collecteur (C) ou le drain, dans lequel il est prévu en série avec le condensateur (C1) un circuit en parallèle composé d'une résistance (R3) et d'un diode (V2), dans lequel la diode (V2) s'éloigne, dans le sens du flux, de la grille (G), **caractérisé en ce qu'**en parallèle au montage composé du condensateur (C1), de la résistance (R3) et de la diode (V2) est monté un autre montage composé d'un autre condensateur (C2), d'une autre résistance (R4) et d'une autre diode (V3), dans lequel en série avec l'autre condensateur (C2) est prévu un circuit en parallèle composé de l'autre résistance (R4) et de l'autre diode (V3), et dans lequel l'autre diode (V3) est dirigée, dans le sens de flux, vers la grille (G).

2. Montage (1) suivant la revendication 1, dans lequel il est prévu un montage de résistance de grille, comprenant une première résistance (Rg1) de grille connectée à la grille (G) et avec laquelle est monté en parallèle un circuit série composé d'une deuxième résistance (Rg2) de grille et d'une diode (V1) de grille, la diode (V1) de grille étant dirigée, dans le sens de flux, vers la grille (G).

3. Montage (1) suivant l'une des revendications précédentes, dans lequel l'interrupteur (T1) à semiconducteur est constitué sous la forme d'un IGBT ou d'un MOSFET.
